# EUROPEAN PATENT APPLICATION

(11) **EP 2 840 307 A1**
(43) Date of publication of application: **25.02.2015**
(21) Application number: 14181095.2
(22) Date of filing: 14.08.2014
(51) Int. Cl.: F21V 17/10, G02B 7/02, F21V 5/04, G02B 19/00, G02F 1/1335, H04N 5/225, H01L 33/48

(54) **Illumination device and display device**

(30) Priority: 20.08.2013 JP 2013170811
(71) Applicant: Funai Electric Co., Ltd., Daito city Osaka 574-0013 (JP)
(72) Inventor: Suzuki, Tomokazu, Osaka, Osaka 574-0013 (JP); Tanabe, Noritaka, Osaka, Osaka 574-0013 (JP); Nameda, Makoto, Osaka, Osaka 574-0013 (JP)
(74) Representative: Osha Liang SARL

(57) **Abstract**

An illumination device that includes a substrate (22); a light-emitting diode or LED (23) disposed on the substrate (22); and a lens (21) that faces the LED and widens a light-distribution angle of light emitted from the LED. The lens (21) includes a plurality of legs (21a, 21c) adhered to the substrate by an adhesive (24), and each of the plurality of legs includes a contact surface that is curved in a convex shape.

## Description

The invention generally relates to an illumination device and a display device, and more particularly to a structure of a lens that widens a light-distribution angle of light emitted from a light-emitting diode (LED).

### [Background Art]

Conventional display devices such as a liquid crystal display device use a direct type backlight of that irradiates light to a display panel (for example, see Patent Literature 1). An LED and a lens that widens a light-distribution angle of light emitted from the LED are used for the backlight, but a positional relationship between the LED and the lens affects an optical characteristic of the backlight. Because of this, there is a need for position determination of the lens so that the positional relationship between the LED and the lens matches a design value.

The lens is adhered to a substrate by an adhesive. The LED is mounted on the substrate. For example, the lens is mounted on the substrate by a mounter (mounting device or tool to mount a lens on a substrate) seeking a center of the lens from an external shape of the lens by image processing, a mounting position of the lens being sought from a position of a recognition mark provided on the substrate, and the lens being mounted in the sought mounting position.

### [Patent Literature]

Patent Literature 1: Japanese Unexamined Patent Application Publication No. 2012-204025

However, due to the adhesive, the lens may not contact the substrate and may be spaced apart from the substrate. Because of this, the light-distribution angle of the light emitted from the LED does not coincide with the design value and, when this light is irradiated to the display panel, unevenness in brightness and variations in chromaticity occur.

### [Summary of the Invention]

One or more embodiments of the invention are directed to an illumination device and a display device that reduces unevenness in brightness and variations in chromaticity in a display panel.

An illumination device according to one or more embodiments of the invention may comprise a substrate, a light-emitting diode (LED) disposed on the substrate, and a lens that faces the LED and widens a light-distribution angle of light emitted from the LED, wherein the lens may comprise a plurality of legs adhered to the substrate by an adhesive, and wherein each of the plurality of legs may comprise a contact surface that is curved in a convex shape.

According to one or more embodiments of the invention, the adhesive is more likely to flow to a side of the leg when pressing the leg of the lens to the substrate because the contact surface of the leg is curved in the convex shape. Because of this, for example, the leg of the lens and the substrate can be reliably contacted and the lens can be position-determined so a positional relationship between the LED and the lens matches a design value. Therefore, when the illumination device is used as a backlight of the display device, unevenness in brightness and variation in chromaticity in the display panel can be reduced.

According to one or more embodiments of the invention, the contact surface of each of the plurality of legs may have a spherical cap shape.

According to one or more embodiments of the invention, for example, the leg of the lens can more easily contact the substrate at a point. As a result, for example, the lens can be position-determined so the positional relationship between the LED and the lens matches the design value. Therefore, when the illumination device is used as the backlight of the display device, unevenness in brightness and variation in chromaticity in the display panel can be reduced.

Furthermore, according to one or more embodiments of the invention, the contact surface of each leg may comprise a groove.

According to one or more embodiments of the invention, for example, when pressing the leg of the lens to the substrate, the adhesive is more likely to flow to the side of the leg by being conducted along the groove.

Furthermore, the contact surface of each leg may have a groove that extends in radially (or in a radial direction) from a central portion of the contact surface.

According to one or more embodiments of the invention, for example, when pressing the leg of the lens to the substrate, the adhesive is more likely to flow to the side of the leg by being conducted along a groove from a center of the leg.

Furthermore, according to one or more embodiments of the invention, a side surface of each of the plurality of legs may be an uneven surface.

According to one or more embodiments of the invention, for example, a surface area of the side surface of the leg of the lens can be increased. Therefore, compared to a situation where there is no unevenness on the side surface of the leg of the lens, shear strength generated between the leg of the lens and the adhesive can be increased. As a result, for example, the lens can be prevented from peeling from the substrate.

According to one or more embodiments of the invention, a grain finish may be applied to the side surface of each leg.

According to one or more embodiments of the invention, for example, when a grain finish may be applied to the side surface of each leg, a surface area of the side surface of the leg of the lens can be increased by a simple manufacturing method.

A display device according to one or more embodiments of the invention is provided with a display panel and the illumination device described above that irradiates light to the display panel.

According to one or more embodiments of the invention, for example, operations and effects similar to that of the illumination device described above can be exhibited.

According to one or more embodiment of the invention, the illumination device and the display device that make unevenness in brightness and variations in chromaticity less likely to occur in the display panel can be provided.

### [Brief Description of the Drawings]

FIG. 1A is an external view of a liquid crystal display that is an example of a display device according to one or more embodiments of the invention.
FIG. 1B is an exploded perspective view of the liquid crystal display illustrated in FIG. 1A.
FIG. 2 is a diagram enlarging a periphery of a backlight unit according to one or more embodiments of the invention.
FIG. 3A is a line A-A cross-sectional view of FIG. 2.
FIG. 3B is an enlarged view of a leg illustrated in FIG. 3A.
FIG. 3C is an enlarged perspective view of a leg according to one or more embodiments of the invention.
FIG. 4 is a diagram of a lens illustrated in FIG. 3A when viewed from a rear surface side (side of a substrate).
FIG. 5A is a diagram for describing an installation example of a lens when a contact surface of each leg is of a planar shape.
FIG. 5B is a diagram for describing an installation example of the lens when the contact surface of each leg is of the planar shape.
FIG. 6A is an enlarged view of the leg illustrated in FIG. 3A.
FIG. 6B is an enlarged perspective view of the leg according to one or more embodiments of the invention.
FIG. 7 is an enlarged view of the leg illustrated in FIG. 3A.
FIG. 8 is an enlarged perspective view of a leg of the lens according to one or more embodiments of the invention.
FIG. 9A is a front surface view of the leg according to one or more embodiments of the invention.
FIG. 9B is a right side surface view of the leg according to one or more embodiments of the invention.
FIG. 9C is a perspective view of the leg according to one or more embodiments of the invention.
FIG. 10 is another front surface view of the leg according to one or more embodiments of the invention.

### [Detailed Description of the Embodiments]

Examples of one or more embodiments of the invention will be described in detail below using the drawings. Each of the embodiments that will be described below illustrates examples of the present invention. Numerical values, shapes, materials, components, disposition positions and connection modes of the components, and the like are examples and are not intended to limit the present invention.

Each figure is a schematic diagram for purposes of illustration only and should not be interpreted to limit scope of the invention. Moreover, in each diagram, identical reference numerals are attached to identical or substantially identical configurations, and redundant descriptions are omitted or simplified.

### (First Example)

A display device according to one or more embodiments of a first example will be described with reference to the drawings.

### [1-1. Overall Configuration of Liquid Crystal Display (Display Device)]

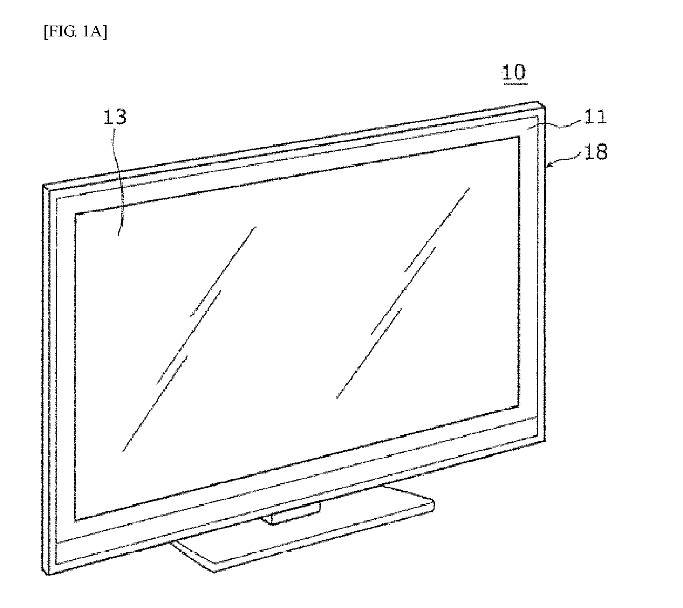

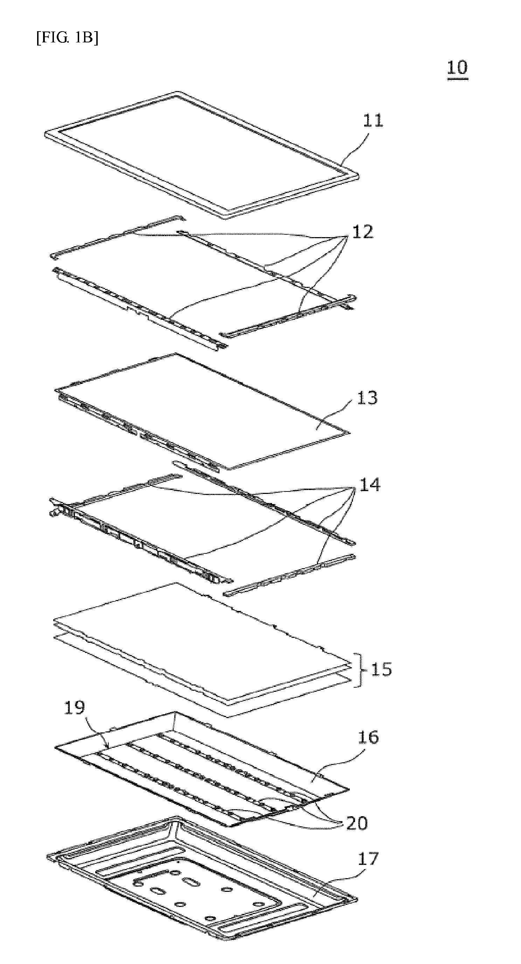

First, an overall configuration of the display device will be described with reference to FIGS. 1A and 1B. FIG. 1A is an external view of a liquid crystal display 10 that is an example of the display device according to one or more embodiments of the invention. FIG. 1B is an exploded perspective view of the liquid crystal display 10 illustrated in FIG. 1A.

According to one or more embodiments, the liquid crystal display 10 is provided with an enclosure 18, and the enclosure 18 comprises a front cabinet 11 and a rear frame 17.

According to one or more embodiments, the front cabinet 11 is in a frame shape and covers an outer peripheral portion of a liquid crystal cell 13 (configuring a display panel) that will be described below. The front cabinet 11 is formed, for example, from resin.

According to one or more embodiments, the rear frame 17 is disposed so as to cover a back surface side of the liquid crystal cell 13.

### [1-2. Interior Configuration of Liquid Crystal Display (Display Device)]

According to one or more embodiments, a bezel 12, the liquid crystal cell 13, a cell guide 14, an optical sheet 15, a reflective sheet 16, and a backlight unit 19 are disposed inside the enclosure 18.

According to one or more embodiments, the bezel 12 is disposed on a top surface side (that is, a side on which the liquid crystal cell 13 is disposed) of the cell guide 14 and covers an outer peripheral portion on a front surface side of the liquid crystal cell 13.

According to one or more embodiments, the liquid crystal cell 13 is in a panel shape of a rectangular shape. The outer peripheral portion of the liquid crystal cell 13 is supported by a cell guide 14 of a frame shape. An image is displayed on the liquid crystal cell 13 by light from the backlight unit 19 that is irradiated to a back surface of the liquid crystal cell 13.

According to one or more embodiments, the optical sheet 15 comprises a plurality of members, such as a diffuser panel and the like. The optical sheet 15 has, for example, a function of diffusing the light from the backlight unit 19.

According to one or more embodiments, the reflective sheet 16 is disposed to cover an inner surface (that is, a surface on a side on which the liquid crystal cell 13 is disposed) of the rear frame 17. The reflective sheet 16 has a function of reflecting the light from the backlight unit 19 toward the back surface of the liquid crystal cell 13.

According to one or more embodiments, the backlight unit 19 is an illumination device of a direct type method and irradiates light toward the back surface of the liquid crystal cell 13. The backlight unit 19 has one or more LED bars 20 (configuring the illumination device).

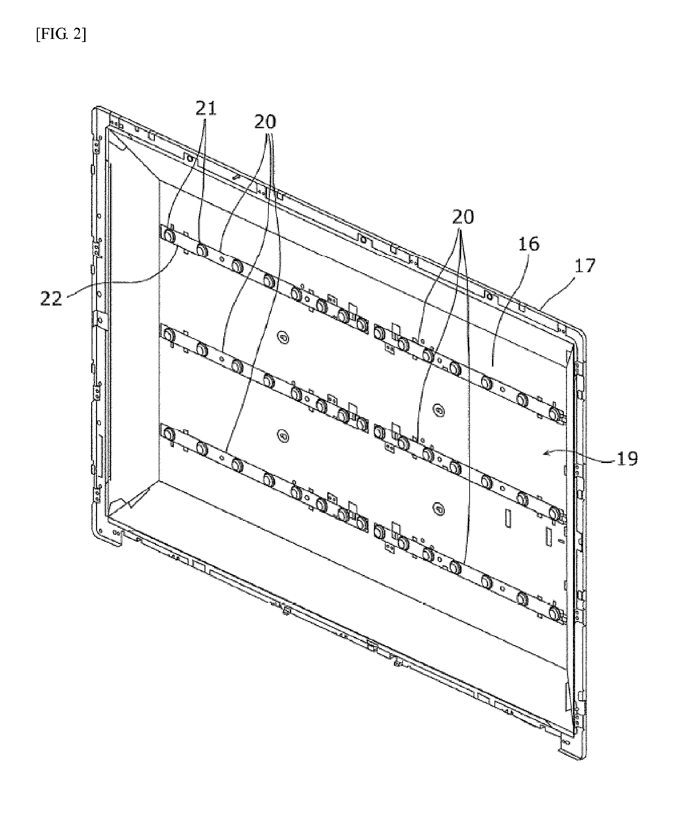

FIG. 2 is a diagram enlarging a periphery of the backlight unit 19 according to one or more embodiments. The backlight unit 19 is configured, for example, by six LED bars 20. However, the number of the LED bars 20 is not limited thereto. The LED bar 20 has a substrate 22 and a plurality of LED units 28 mounted on the substrate 22. The substrate 22 is configured in a plate shape of an elongated shape. The plurality of LED units 28 is disposed in one row and at intervals along a lengthwise direction of the substrate 22. The substrate 22 is attached to the inner surface of the rear frame 17 by a double-sided tape having thermal conductivity (not illustrated). The substrate 22 is formed from a metal with high thermal conductivity, for example, aluminum.

### [2. Configuration of LED Bar (Illumination Device)]

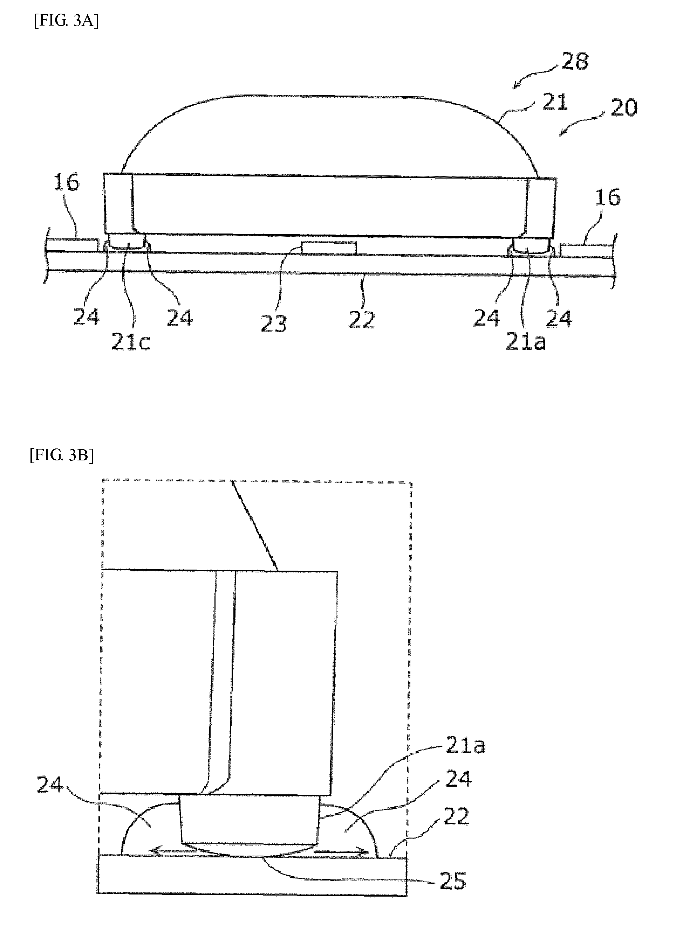

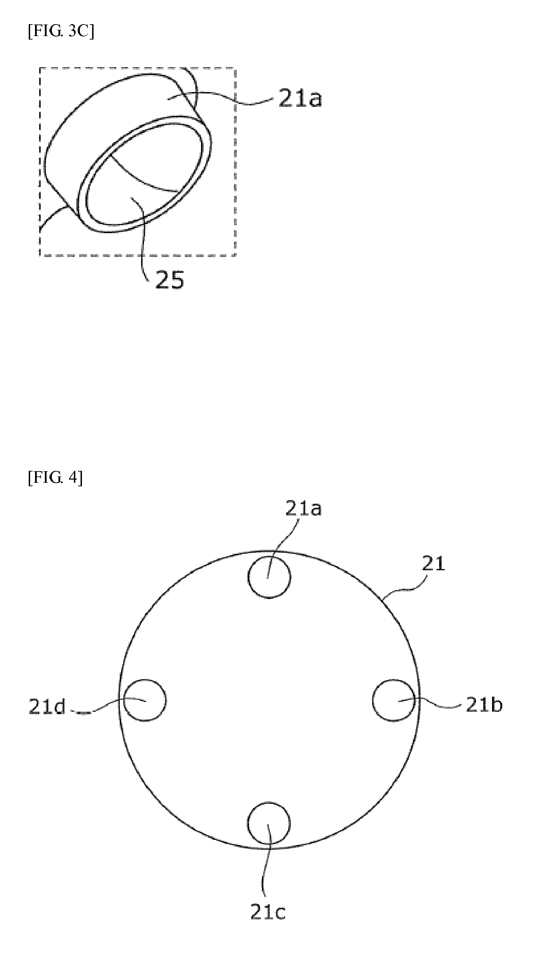

FIG. 3A is a line A-A cross-sectional view of FIG. 2 according to one or more embodiments. FIG. 3B is an enlarged diagram of a leg 21a illustrated in FIG. 3A. FIG. 3C is an enlarged perspective view of the leg 21a. FIG. 4 is a diagram of a lens 21 illustrated in FIG. 3A when viewed from a rear surface side (side of the substrate 22).

According to one or more embodiments as illustrated in FIG. 3A, each of the plurality of LED units 28 disposed on the LED bar 20 includes an LED 23 and the lens 21. The LED 23 is mounted on the substrate 22, and the lens 21 is disposed opposite the LED 23. The lens 21 fulfils a function of widening a light-distribution angle of light emitted from the LED 23. As illustrated in FIG. 4, four legs 21a to 21d are formed on a peripheral portion of a rear surface of the lens 21. The four legs 21a to 21d are adhered to the substrate 22 by an adhesive 24. Illustrations of the leg 21b and the leg 21 d in FIG. 3A are omitted only for clarification purposes. Moreover, the number of legs of the lens 21 is not limited to four and is sufficient if there exist three or more, for example.

As illustrated in FIGS. 3B and 3C, according to one or more embodiments, a contact surface 25 of the leg 21a is curved in a convex shape. Specifically, the contact surface 25 has a circular shape, a peripheral portion of the contact surface 25 is in a planar shape, and a shape of an inner side of the peripheral portion is a spherical cap shape. Contact surfaces of the other legs 21b to 21d also have shapes similar to the contact surface 25. Being curved overall in the convex shape indicates that, ideally, a portion that is 90% or more of the contact surface 25 is curved in the convex shape.

According to one or more embodiments, the lens 21 is fixed to the substrate 22 in the following manner. That is, the adhesive 24 is applied in advance to a position on the substrate 22 where the legs 21 a to 21 d make contact. A mounter fixes the lens 21 to the substrate 22 by pressing the contact surface 25 of the legs 21a to 21d of the lens 21 to the substrate 22 applied with the adhesive 24.

According to one or more embodiments, the contact surface 25 of the legs 21a to 21d is curved in a convex shape. Because of this, as illustrated in FIG. 3B, when pressing the leg 21a of the lens 21 to the substrate 22, a tip of the contact portion 25 first contacts the adhesive 24, and the contact surface 25 is pressed to the substrate 22 while the contact surface 25 pushes away the adhesive 24 to a side (direction of the arrows) of the leg 21a. That is, it becomes easier to flow the adhesive 24 to the side (direction of the arrows) of the leg 21a. Similarly, with the other legs 21b to 21d, it becomes easier to flow the adhesive 24 to a side of each leg. As a result, each leg of the lens 21 and the substrate 22 can reliably contact each other. In particular, because a shape of the contact surface 25 of the legs 21a to 21d is a spherical cap shape, it becomes easier for each leg to contact the substrate 22 at a point. As a result, the lens 21 can be position-determined so a positional relationship between the LED 23 and the lens 21 matches a design value. Therefore, when the LED bar 20 is used as a backlight of the liquid crystal display 10, it is less likely for unevenness in brightness and variation in chromaticity to occur in the liquid crystal cell 13.

### [3. Comparative Configuration]

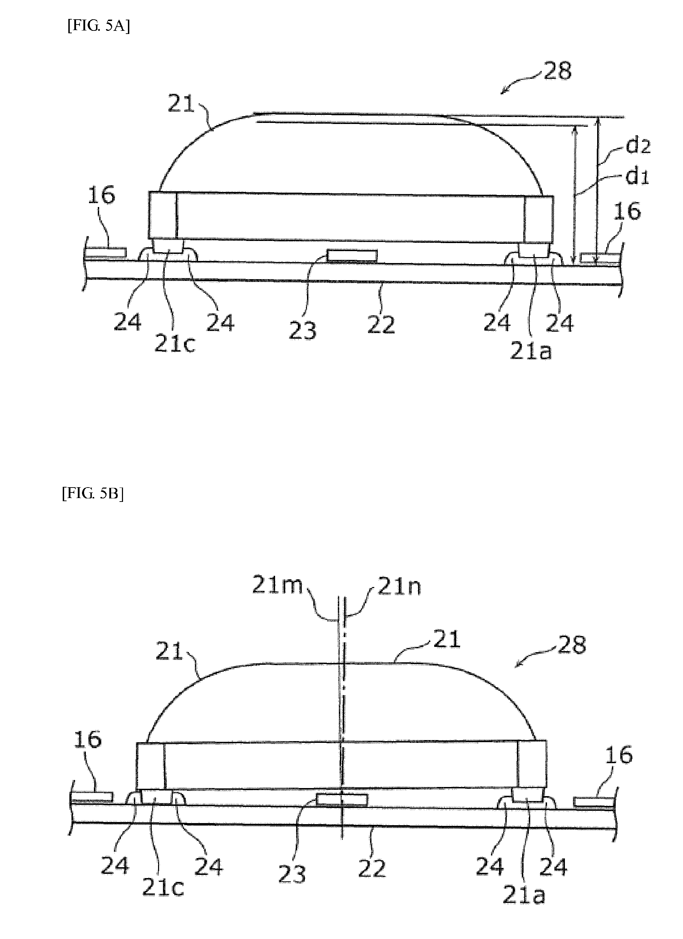

In contrast, a situation where a contact surface of each leg is a planar shape will be described. FIGS. 5A and 5B are diagrams for describing an installation example of the lens 21 when the contact surface of each leg is of the planar shape. In the situation where the contact surface is of the planar shape, when the mounter presses the legs 21a to 21d of the lens 21 to the substrate 22 applied with the adhesive 24, it is difficult to flow the adhesive 24 to the side of each leg because the contact surface and the adhesive 24 make contact at a surface from when adhesion begins. Because of this, as illustrated in FIG. 5A, the contact surface of each leg cannot be contacted to the substrate 22, and fixing occurs in a state of being floated from the substrate 22. In this situation, a distance d2 from the substrate 22 to a tip of the lens 21 becomes greater than a distance d1 established by the design value. In this manner, position determination of the lens 21 cannot be performed precisely, and unevenness in brightness and variation in chromaticity occur in the liquid crystal cell 13. Moreover, as illustrated in FIG. 5B, the leg 21c contacts the substrate 22, but the leg 21a is also fixed in the state of being floated from the substrate 22. In this situation, an optical axis 21m of the lens 21 becomes inclined relative to an optical axis 21n established by the design value. Because of this, position determination of the lens 21 cannot be performed precisely, and unevenness in brightness and variation in chromaticity occur in the liquid crystal cell 13.

### [4. Effects]

As described above, according to one or more embodiments of the first example, the lens 21 can reliably contact the substrate 22. Because of this, unevenness in brightness and variation in chromaticity can be reduced in the liquid crystal cell 13.

### (Modifying one or more embodiments of the first example)

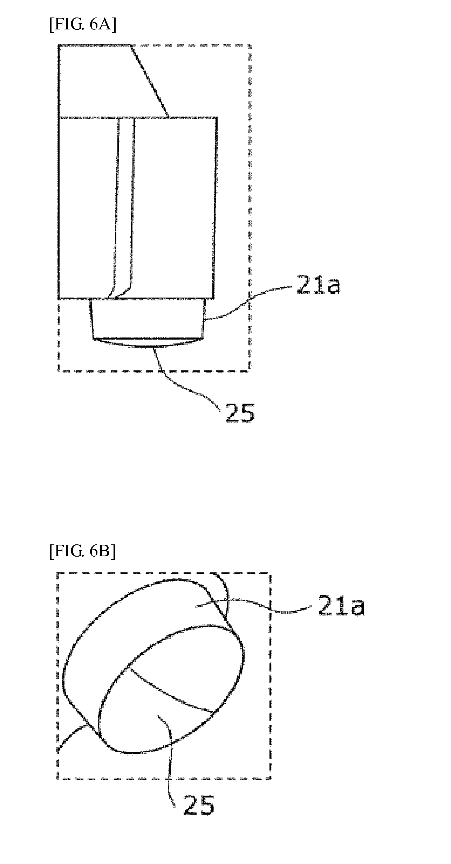

In one or more embodiments of the first example, there may be a portion of a partially planar shape in the peripheral portion of the contact surface 25 of each leg of the lens 21, but an entirety of the contact surface 25 may be curved. FIG. 6A is an enlarged view of the leg 21a illustrated in FIG. 3A. FIG. 6B is an enlarged perspective view of the leg 21a. The shapes of the legs 21b to 21d are also similar.

According to one or more embodiments as illustrated in these diagrams, the entirety of the contact surface 25 may be curved in a convex shape. Specifically, the entirety of the contact surface 25 may be of a spherical cap shape.

### (Second Example)

In one or more embodiments of the first example, the contact surface 25 of each leg of the lens 21 is made to be of the spherical cap shape. In addition, according to one or more embodiments of a second example, a side surface of each leg may be uneven.

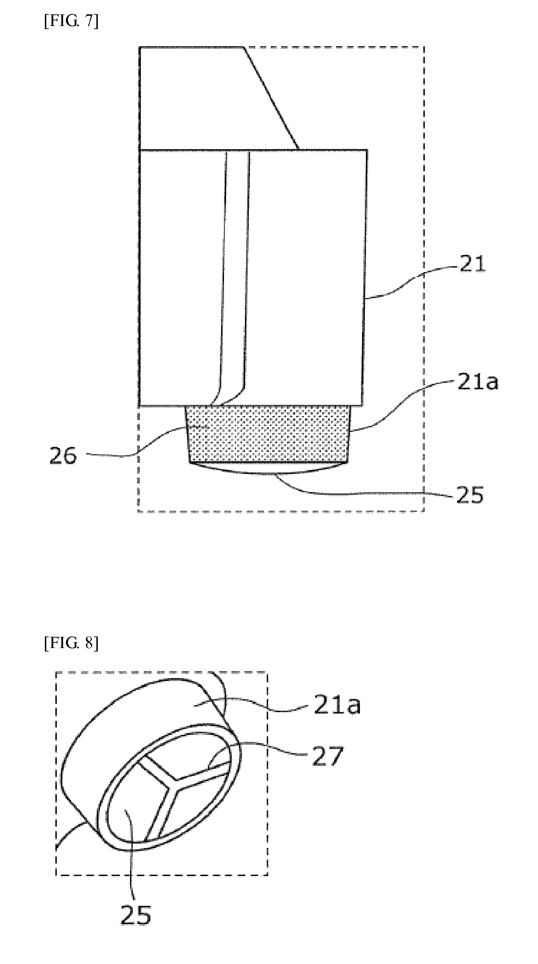

FIG. 7 is an enlarged diagram of the leg 21a illustrated in FIG. 3A according to one or more embodiments. As illustrated in FIG. 7, a side surface 26 of the leg 21a may be uneven. For example, an uneven surface may be grainy, patterned, or the like. For example, a grain finish may be applied to the side surface 26. The shape of the side surface 26 of the legs 21b to 21d may be similarly uneven.

According to one or more embodiments of the invention, a surface area of the side surface 26 of the leg of the lens 21 can be increased. Therefore, shear strength generated between the leg of the lens 21 and the adhesive 24 can be increased compared to a situation where there is no unevenness on a side surface of a leg of a lens. As a result, the lens 21 can be prevented from peeling from the substrate 22. Moreover, by applying the grain finish on the side surface 26, the surface area of the side surface 26 can be increased by a simple manufacturing method.

According to one or more embodiments, the shape of the side surface 26 is not limited to that which is illustrated and may be any shape so long it is uneven.

### (Third Example)

In one or more embodiments of the first example, the contact surface 25 of each leg of the lens 21 is made to be of the spherical cap shape. In one or more embodiments of a third example, the contact surface 25 is of the spherical cap shape and has a groove.

FIG. 8 is an enlarged perspective view of the leg 21a of the lens 21 according to one or more embodiments. The shapes of the legs 21b to 21d are also similar. A groove 27 is provided in the contact surface 25 of the leg 21a. Note that the groove 27 may extend in a radial shape from a center or near the center of the contact surface 25.

According to one or more embodiments, when pressing the leg of the lens 21 to the substrate 22, the adhesive 24 is more likely to flow to the side of the leg by being conducted along the groove 27.

### (Fourth Example)

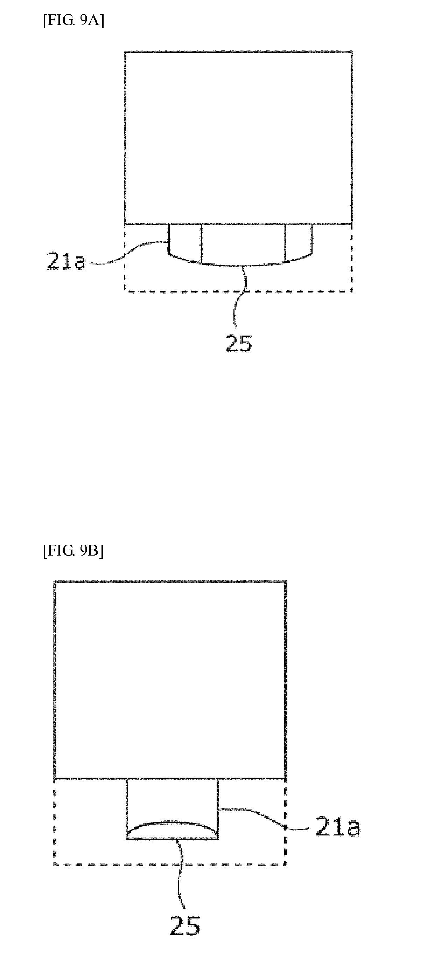

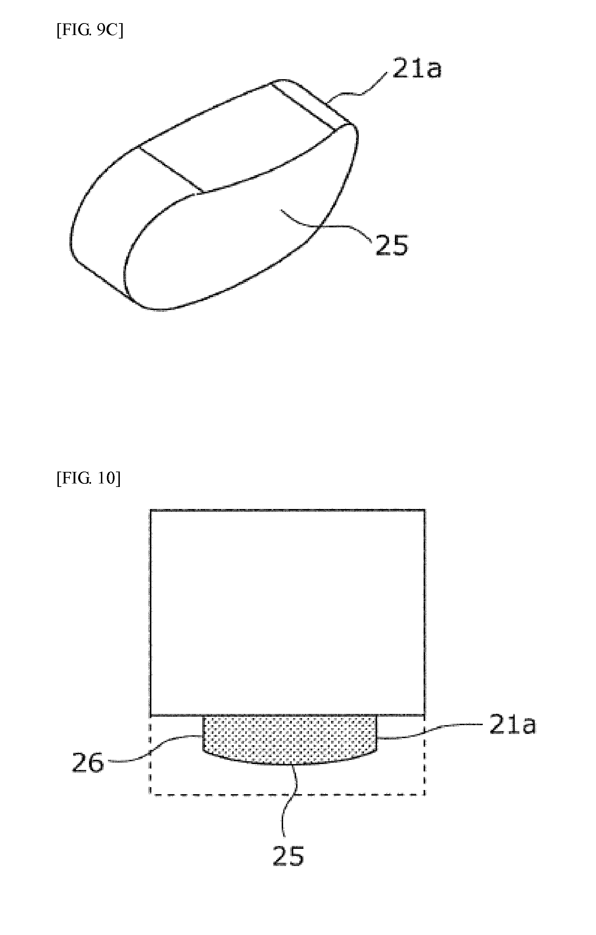

In one or more embodiments of the first example, the contact surface 25 of each leg of the lens 21 is of a circular shape, but the shape of the contact surface 25 is not limited to the circular shape. FIG. 9A is a front view of a leg 21a according to one or more embodiments of a fourth example. FIG. 9B is a right side surface view of the leg 21a according to one or more embodiments of the fourth example. FIG. 9C a perspective view of the leg 21a. The shapes of the legs 21b to 21d are also similar.

According to one or more embodiments as illustrated in these figures, the leg 21 a has an elongated elliptical shape and is curved so as to be a convex shape when viewed from the front. Accordingly, as can be seen from the figures, when viewed from a rear surface side, the contact surface 25 of the leg 21a may be delimited by an elongated ellipse or oval having a major axis and a minor axis intersecting at the center of the ellipse, and two antipodal points at the ends of the major axis. Due to the convex shape, the antipodal points are farther away from the substrate 22 than the center of the contact surface 25.

In one or more embodiments of the invention, when the leg 21 a of the lens 21 is pressed to the substrate 22, it becomes easier to flow the adhesive 24 in a lateral direction when viewing the leg 21a from the front, as in FIG. 9A.

According to one or more embodiments as illustrated in FIG. 10, the side surface 26 of the leg 21a may be uneven. Specifically, the grain finish may be applied to the side surface 26.

Although the disclosure has been described with respect to only a limited number of embodiments, those skilled in the art, having benefit of this disclosure, will appreciate that various other embodiments may be devised without departing from the scope of the present invention. Accordingly, the scope of the present invention should be limited only by the attached claims.

The examples above, and their modified examples, may also be combined with each other. For example, the grain finish may be applied to a side surface of the leg 21a according to one or more embodiments of the third example illustrated in FIG. 8.

### [Industrial Applicability]

One or more embodiments of the invention is, for example, a display device for a television receiver or the like that plays or records a television broadcast.

### [Reference Numerals]

- 10: Liquid crystal display
- 11: Front cabinet
- 12: Bezel
- 13: Liquid crystal cell
- 14: Cell guide
- 15: Optical sheet
- 16: Reflective sheet
- 17: Rear frame
- 18: Enclosure
- 19: Backlight unit
- 20: LED bar
- 21: Lens
- 21a to 21d: Leg
- 21m, 21n: Optical axis
- 22: Substrate
- 23: LED
- 24: Adhesive
- 25: Contact surface
- 26: Side surface
- 27: Groove
- 28: LED unit

## Claims

1. An illumination device, comprising:
a substrate (22);
a light-emitting diode or LED (23) disposed on the substrate; and
a lens (21) that faces the LED and widens a light-distribution angle of light emitted from the LED, wherein
the lens (21) comprises a plurality of legs (21a-21d) adhered to the substrate by an adhesive (24), and
each of the plurality of legs comprises a contact surface (25) that is curved in a convex shape.

2. The illumination device according to claim 1, wherein the contact surface (25) of each of the plurality of legs (21a-21d) has a spherical cap shape.

3. The illumination device according to claim 1 or 2, wherein the contact surface of each of the plurality of legs (21a-21d) comprises a groove (27).

4. The illumination device according to claim 3, wherein the groove (27) extends radially from a center of the contact surface (25).

5. The illumination device according to any of claims 1 to 4, wherein a side surface (26) of each of the plurality of legs (21a-21d) is an uneven surface.

6. The illumination device according to claim 5, wherein the uneven surface has a grain finish.

7. The illumination device according to claim 1, wherein each of the plurality of legs (21a-21d) contacts the substrate (22) at a point.

8. The illumination device according to claim 1, wherein each of the plurality of legs (21a-21d) has an elongated elliptical shape.

9. A display device, comprising:
a display panel; and
an illumination device according to any of claims 1 to 8.
